# EUROPÄISCHE PATENTSCHRIFT

(11) **EP 2 736 836 B1**
(45) Veröffentlichungstag und Bekanntmachung des Hinweises auf die Patenterteilung: **18.01.2023**
(21) Anmeldenummer: 12740157.8
(22) Anmeldetag: 26.07.2012
(51) Int. Cl.: B81B 7/00, H01L 23/045, H01L 29/84

(54) **GEHÄUSE FÜR EINEN HALBLEITERCHIP UND HALBLEITERCHIP MIT EINEM GEHÄUSE**
HOUSING FOR SEMICONDUCTOR CHIP AND SEMICONDUCTOR CHIP WITH A HOUSING
BOÎTIER POUR UNE PUCE SEMICONDUCTRICE ET PUCE SEMICONDUCTRICE MUNIE D'UN BOÎTIER

(30) Priorität: 29.07.2011 DE 102011109006
(43) Veröffentlichungstag der Anmeldung: 04.06.2014
(73) Patentinhaber: TDK Electronics AG, 81671 München (DE)
(72) Erfinder: KUBIAK, Michael, 14974 Ludwigsfelde OT Siethen (DE)
(74) Vertreter: Epping - Hermann - Fischer
(86) Internationale Anmeldenummer: PCT/EP2012/064724
(87) Internationale Veröffentlichungsnummer: WO 2013/017530

(56) Entgegenhaltungen:
- US-A1- 2007 210 392
- US-A1- 2008 041 607
- US-A1- 2008 128 886
- US-A1- 2009 090 531
- US-A1- 2010 067 732
- US-A1- 2011 030 989

## Beschreibung

Es wird ein Gehäuse für einen Halbleiterchip angegeben. Vorzugsweise schützt das Gehäuse den Halbleiterchip vor einer Beschädigung, beispielsweise vor mechanischen oder chemischen äußere Einwirkungen. Weiterhin wird ein Halbleiterchip mit einem Gehäuse angegeben. Der Halbleiterchip ist beispielsweise zur Messung eines Drucks ausgebildet. Alternativ kann der Halbleiterchip beispielsweise als Inertialsensor, insbesondere zur Messung einer Beschleunigung ausgebildet sein. Alternativ kann der Halbleiterchip beispielsweise als Magnetsensor, beispielsweise zur Messung von Drehzahlen, ausgebildet sein.

Alternativ kann der Halbleiterchip beispielsweise als eine Kombination aus zwei oder mehr Sensortypen aus einem Drucksensor, einem Inertialsensor oder einem Magnetsensor ausgebildet sein.

Aus den Patentanmeldungen US 2010/067732 A1 und US 2007/0210392 A1 sind jeweils ein Gehäuse für einen Halbleiterchip bekannt, bei dem ein Leadframe in Gussharz eingebettet ist. Bei der US 2007/0210392 A1 weist der Leadframe Anschlusspins auf, die aus dem Gussharz herausragen.

Die Patentanmeldungen US 2008/0128886 A1, US 2008/0041607 A1, US 2011/0030989 A1 und US 2009/0090531 A1 zeigen verschiedene Gehäuse für elektrische Komponenten.

Es ist eine zu lösende Aufgabe, ein Gehäuse für einen Halbleiterchip und einen Halbleiterchip mit einem Gehäuse anzugeben, wobei das Gehäuse verbesserte Eigenschaften aufweist.

Es wird ein Gehäuse für einen Halbleiterchip angegeben, wobei das Gehäuse einen spritzgegossenen Körper aufweist, in dem ein Aufnahmeraum zur Aufnahme des Halbleiterchips vorgesehen ist. Der spritzgegossene Körper weist wenigstens eine Metallisierung zur elektrischen Kontaktierung des Halbleiterchips auf.

Erfindungsgemäß weist der spritzgegossene Körper Anschlusspins auf, die aus mit Metallisierungen versehenen Teilen des Körpers gebildet sind.

Der spritzgegossene Körper erfüllt somit zugleich die Funktion eines Gehäuses für den Halbleiterchip und die Funktion eines Schaltungsträgers zur elektrischen Kontaktierung des Halbleiterchips. Auf diese Weise kann die Anzahl von Bauteilen, die zur Ausbildung eines Gehäuses und eines Schaltungsträgers benötigt werden, verringert werden. Zudem können bei einem derartigen Gehäuse besonders geringe Fertigungstoleranzen erzielt werden.

Vorzugsweise ist der spritzgegossene Körper als "Molded Interconnect Device" (englisch für spritzgegossener Schaltungsträger), kurz MID, ausgebildet. Vorzugsweise weist der spritzgegossene Körper zumindest zwei verschiedene Material-Komponenten auf, wobei ein Material metallisierbar und das andere Material nicht-metallisierbar ist. Auf das metallisierbare Material können die Metallisierungen aufgebracht werden. Beide Materialien sind vorzugsweise nicht-leitende Materialien.

Vorzugsweise weist der spritzgegossene Körper ein Kunststoff-Material auf. Besonders bevorzugt weist der spritzgegossene Körper eine Komponente eines nicht-metallisierbaren Kunststoffs auf und eine Komponente eines metallisierbaren Kunststoffs auf.

Der Körper ist beispielsweise in einem Zweikomponenten-Spritzgussverfahren hergestellt. Dabei kann in einem ersten Spritzguss-Schritt aus einem ersten Material ein Grundkörper geformt werden und in einem zweiten Spritzguss-Schritt ein zweites Material auf den Grundkörper aufgebracht werden. Anschließend können die Metallisierungen auf das - metallisierbare Material, welches vorzugsweise das zweite Material ist, aufgebracht werden.

Vorzugsweise ist das Gehäuse derart ausgebildet, dass ein Halbleiterchip, der im Aufnahmeraum angeordnet ist, vom spritzgegossenen Körper vollständig umgeben ist oder bis auf eine offene Seite des spritzgegossenen Körpers, d.h., in fünf Raumrichtungen, vom Gehäuse umgeben ist. Beispielsweise ist der Aufnahmeraum als Vertiefung in dem spritzgegossenen Körper ausgebildet. Der spritzgegossene Körper kann die Form eines Quaders aufweisen, der auf einer Seitenfläche offen ist. Die Form des spritzgegossenen Körpers ist vorzugsweise an das jeweilige Einsatzgebiet angepasst.

Das Gehäuse weist vorzugsweise einen Boden auf, der derart ausgebildet ist, dass an ihm der Halbleiterchip befestigt werden kann. Vorzugsweise ist der Boden ein Teil des spritzgegossenen Körpers. Beispielsweise kann der Halbleiterchip mittels eines Klebstoffs am Boden befestigt werden.

In einer Ausführungsform des Gehäuses ist die Metallisierung zumindest teilweise auf einer Oberfläche des spritzgegossenen Körpers angeordnet.

Die Metallisierung kann zumindest teilweise im Aufnahmeraum des Gehäuses angeordnet sein.

Beispielsweise ist die Metallisierung auf einem Boden des Gehäuses im Aufnahmeraum vorgesehen. Vorzugsweise ist die Metallisierung derart angeordnet, dass ein Halbleiterchip auf dem Boden des Gehäuses befestigt und mit der Metallisierung elektrisch verbunden werden kann. Die elektrische Verbindung des Halbleiterchips mit der Metallisierung kann beispielsweise durch eine Verdrahtung hergestellt sein, die von elektrischen Kontakten des Halbleiterchips zur Metallisierung führt. Beispielsweise können Drähte an der Metallisierung angelötet werden.

Die Metallisierung ist zumindest teilweise außerhalb des Aufnahmeraums angeordnet sein.

Erfindungsgemäß ist die Metallisierung auf einer äußeren Oberfläche des Gehäuses, beispielsweise auf einer äußeren Oberfläche des Bodens des Gehäuses angeordnet. Die Metallisierung, die außerhalb des Aufnahmeraums angeordnet ist, dient zur äußeren elektrischen Kontaktierung des Halbleiterchips. Erfindungsgemäß weist die Metallisierung, die außerhalb des Aufnahmeraums angeordnet ist, einen elektrischen Anschluss in Form eines Kontaktpins auf. Erfindungsgemäß sind Kontaktpins durch eine entsprechende Formgebung des spritzgegossenen Körpers und einer Metallisierung gebildet. In diesem Fall müssen keine separaten Kontaktpins am Gehäuse befestigt werden.

Beispielsweise ist das Gehäuse derart ausgebildet, dass es auf eine Leiterplatte aufgesetzt werden kann. Zum elektrischen Anschluss des Halbleiterchips kann eine Metallisierung des Gehäuses mit einer Leiterbahn der Leiterplatte elektrisch verbunden werden. Vorzugsweise weist das Gehäuse eine Metallisierung auf, die auf einer äußeren Oberfläche des Gehäuses angeordnet ist, und ist derart ausgebildet, dass es mit der Seite, auf der die Metallisierung angeordnet ist, auf die Leiterplatte aufgesetzt wird. In diesem Fall kann eine elektrische Verbindung der Metallisierungen mit der Leiterplatte ohne zusätzliches Anbringen von Verbindungsdrähten erfolgen. Beispielsweise ist eine Metallisierung des Gehäuses mit einer Leiterbahn der Leiterplatte verlötet.

Besonders bevorzugt weist das Gehäuse wenigstens eine Metallisierung auf einer Oberfläche des spritzgegossenen Körpers im Aufnahmeraum und wenigstens eine Metallisierung auf einer äußeren Oberfläche des spritzgegossenen Körpers auf, wobei die Metallisierungen elektrisch miteinander verbunden sind. Auf diese Weise kann eine elektrische Kontaktierung des Halbleiterchips von außen ermöglicht werden.

In einer Ausführungsform führt die Metallisierung zumindest teilweise durch den spritzgegossenen Körper hindurch.

Vorzugsweise bildet die Metallisierung eine Durchkontaktierung des spritzgegossenen Körpers, d.h., sie führt durch eine Wand des spritzgegossenen Körpers vollständig hindurch. Eine derartige Durchkontaktierung stellt eine elektrische Verbindung vom Außenraum zum Innenraum des Körpers her und ermöglicht somit eine elektrische Kontaktierung des Halbleiterchips von außerhalb des Gehäuses. Bei einer Durchkontaktierung kann ein besonders dichtes Gehäuse realisiert werden.

In einer Ausführungsform weist der spritzgegossene Körper wenigstens eine Metallisierung auf, die im Aufnahmeraum angeordnet ist. Beispielsweise ist diese Metallisierung auf einer inneren Oberfläche des Körpers angeordnet. Zudem weist der spritzgegossene Körper wenigstens eine als Durchkontaktierung ausgebildete Metallisierung auf, die durch den spritzgegossenen Körper hindurch führt. Zudem weist der Körper wenigstens eine Metallisierung auf, die außerhalb des Aufnahmeraums angeordnet ist. Vorzugsweise ist diese Metallisierung auf einer äußeren Oberfläche des spritzgegossenen Körpers angeordnet. Die Durchkontaktierung verbindet die Metallisierung im Aufnahmeraum mit der Metallisierung außerhalb des Aufnahmeraums.

In einer weiteren Ausführungsform ist die Metallisierung zumindest teilweise im Aufnahmeraum vorgesehen und führt entlang einer Oberfläche des spritzgegossenen Körpers aus dem Aufnahmeraum heraus.

In diesem Fall ist der Körper vorzugsweise frei von Durchkontaktierungen. Beispielsweise weist der Körper eine offene Seite auf, durch die die Metallisierung aus dem Aufnahmeraum in einen Außenraum geführt wird. Bei dieser Ausführungsform kann die elektrische Kontaktierung besonders einfach hergestellt werden, da keine Durchkontaktierung erzeugt werden muss.

In einer Ausführungsform weist das Gehäuse einen Deckel zur Verschließung des Aufnahmeraums auf.

Der Deckel kann ein Kunststoff-Material aufweisen. Vorzugsweise ist der Deckel am spritzgegossenen Körper des Gehäuses befestigt. Beispielsweise kann der Deckel durch einen Klebstoff oder mittels Ultraschall-Schweißens am spritzgegossenen Körper befestigt sein. Eine Verbindung mittels Ultraschall-Schweißens hat den Vorteil, dass ein besonders dichtes Gehäuse realisiert werden kann.

Beispielsweise führt im Falle einer Kontaktierung, bei der Metallisierungen an der Oberfläche des Körpers entlang nach außen geführt werden, die Metallisierung zwischen dem Deckel und dem Körper hindurch. In diesem Fall kann das Gehäuse so auf einer Leiterplatte montiert werden, dass der Deckel des Gehäuses an die Leiterplatte angrenzt.

Bei einer alternativen Ausführungsform ist das Gehäuse frei von einem Deckel. Beispielsweise kann dann eine Metallisierung an einer offenen Seite des Körpers aus dem Innenraum herausführen.

In einer Ausführungsform weist das Gehäuse eine Vergussmasse auf, die den Aufnahmeraum zumindest teilweise ausfüllt.

Vorzugsweise ist die Vergussmasse derart ausgebildet, dass der Halbleiterchip vollständig von der Vergussmasse umgeben ist. Dabei ist vollständig so zu verstehen, dass der Halbleiterchip in einem Bereich, in dem er am Gehäuse befestigt ist, frei von der Vergussmasse sein kann. Vorzugsweise bewirkt die Vergussmasse eine Passivierung des Halbleiterchips und von Verbindungsdrähten des Halbleiterchips.

In einer Ausführungsform weist das Gehäuse einen Deckel und eine Vergussmasse auf.

Die Vergussmasse füllt beispielsweise den Aufnahmeraum des Gehäuses vollständig, d.h., bis zum Deckel des Gehäuses. Auf diese Weise kann eine besonders gute Abdichtung des Aufnahmeraums des Gehäuses erfolgen. Die Vergussmasse kann alternativ den Aufnahmeraum des Gehäuses nur teilweise füllen. Beispielsweise lässt die Vergussmasse einen Freiraum zum Deckel frei.

In einer Ausführungsform ist das Gehäuse frei von einem Deckel. In dieser Ausführungsform kann ein Schutz des Halbleiterchips allein durch die Vergussmasse erfolgen.

Vorzugsweise ist das Gehäuse derart ausgebildet, dass der Aufnahmeraum hermetisch dicht abgeschlossen ist.

Für eine hermetisch dichte Verschließung ist vorzugsweise ein Deckel des Gehäuses besonders dicht mit dem Gehäusekörper verbunden. Beispielsweise ist der Deckel mittels UltraschallSchweißens am Gehäuse befestigt. Weiterhin kann durch eine als Durchkontaktierung ausgebildete Metallisierung eine besonders gute Abdichtung des Gehäuses erreicht werden.

In einer Ausführungsform weist das Gehäuse eine Öffnung auf. Beispielsweise führt die Öffnung in den Aufnahmeraum hinein. Beispielsweise kann die Öffnung als Zuleitung für ein Medium, insbesondere ein fluides oder ein gasförmiges Medium ausgebildet sein. Beispielsweise kann die Öffnung zum Druckausgleich, insbesondere zwischen dem Aufnahmeraum und der Umgebung dienen. Insbesondere kann die Öffnung zur Entlüftung des Aufnahmeraums dienen. Alternativ kann die Öffnung zum Befüllen des Aufnahmeraums mit einem Medium, beispielsweise einem Öl dienen. Dies kann dem Schutz des Sensors dienen. Beispielsweise kann der Sensor durch das Öl vor Staub oder anderen Schmutzpartikeln geschützt sein.

Die Öffnung kann an einer Seite des Gehäuses in den Aufnahmeraum führen, und eine oder mehrere Metallisierungen können an einer anderen Seite aus dem Aufnahmeraum herausführen. Beispielsweise können die Metallisierungen an einer der Öffnung gegenüberliegenden Seite aus dem Aufnahmeraum herausführen. Beispielsweise können die Öffnung in einem Deckel und eine oder mehrere Metallisierungen auf oder in einem Gehäuseboden angeordnet sein. Insbesondere können die Metallisierungen durch den Gehäuseboden hindurchführen. Alternativ kann die Öffnung in einem Gehäuseboden angeordnet sein, und eine oder mehreren Metallisierungen an einer Seite, an der ein Deckel angeordnet ist, aus dem Aufnahmeraum herausführen. Insbesondere können eine oder mehrere Metallisierungen entlang der Gehäusewand verlaufen. Insbesondere können eine oder mehrere Metallisierungen entlang der Gehäusewand nach außen führen.

Des Weiteren kann die Öffnung mit einer Membran verschlossen sein. Insbesondere kann die Öffnung mit einer halbdurchlässigen Membran verschlossen sein. Beispielsweise kann die Membran gasdurchlässig und fluiddicht ausgebildet sein. Alternativ oder zusätzlich kann die Membran in eine Richtung durchlässig sein und in eine andere Richtung nicht. Beispielsweise kann dadurch eine Entlüftung des Aufnahmeraums stattfinden. Beispielsweise kann die Membran derart durchlässig ausgebildet sein, dass kein Überdruck im Aufnahmeraum entsteht.

Des Weiteren kann an der Öffnung ein Ventil angeordnet sein. Beispielsweise kann das Ventil für ein fluides Medium oder ein gasförmiges Medium nur in eine Richtung durchlässig sein. Alternativ oder zusätzlich kann das Ventil eine Durchflussgeschwindigkeit des Mediums regulieren. Beispielsweise kann in einem geöffneten Zustand des Ventils ein Austausch von einem gasförmigen oder flüssigen Medium stattfinden. Beispielsweise kann in einem geschlossenen Zustand des Ventils der Aufnahmeraum dicht abgeschlossen sein.

Weiterhin wird ein Halbleiterchip mit einem Gehäuse angegeben. Das Gehäuse kann alle oben beschriebenen funktionellen und strukturellen Merkmale eines Gehäuses aufweisen. Das Gehäuse weist einen spritzgegossenen Körper mit einem Aufnahmeraum auf, wobei der der Halbleiterchip im Aufnahmeraum angeordnet ist.

Vorzugsweise ist der Halbleiterchip an einem Boden des spritzgegossenen Körpers befestigt. Der Halbleiterchip und das zugehörige Gehäuse können zur Messung eines Drucks ausgebildet sein. Alternativ kann der Halbleiterchip zur Messung einer Beschleunigung ausgebildet sein. Alternativ kann der Halbleiterchip zur Messung einer Drehzahl ausgebildet sein. Beispielsweise kann der Halbleiterchip als Magnetsensor ausgebildet sein. Das Gehäuse kann dabei an die jeweilige Funktion des Halbleiterchips angepasst sein. Vorzugsweise verläuft die mindestens eine Metallisierung auf dem spritzgegossenen Körper auf einer Fläche, auf welcher der Halbleiterchip angeordnet ist. Alternativ führt die mindestens eine Metallisierung durch die Fläche hindurch, auf welcher der Halbleiterchip angeordnet ist. Beispielsweise ist der spritzgegossene Körper als MID ausgebildet.

Beispielsweise ist der Halbleiterchip mit seinem Gehäuse zur Messung eines absoluten Drucks ausgebildet. In einer weiteren Ausführungsform kann der Halbleiterchip und das Gehäuse zur Messung eines relativen Drucks ausgebildet sein. Das Gehäuse weist beispielsweise einen Anschlussbereich auf, durch den eine Zuleitung für ein fluides Medium führt. Die Zuleitung führt vorzugsweise auf einen drucksensitiven Bereich des Halbleiterchips zu, sodass der Druck des fluiden Mediums mittels des Halbleiterchips messbar ist. Beispielsweise ist an der Zuleitung eine Membran oder ein Ventil angeordnet.

Im Folgenden werden die hier beschriebenen Gegenstände anhand von schematischen und nicht maßstabsgetreuen Ausführungsbeispielen näher erläutert. Es zeigen:
- Figur 1: eine Schnittansicht einer ersten, nichterfindungsgemäßen Ausführungsform eines Gehäuses,
- Figur 2: eine Aufsicht von außen auf den Boden des Gehäuses aus Figur 1,
- Figur 3: eine Schnittansicht einer zweiten, nichterfindungsgemäßen Ausführungsform eines Gehäuses,
- Figur 4: eine Schnittansicht einer dritten, erfindungsgemäßen Ausführungsform eines Gehäuses,
- Figur 5: eine Aufsicht von außen auf den Deckel des Gehäuses aus Figur 4,
- Figur 6: eine Schnittansicht einer vierten, erfindungsgemäßen Ausführungsform eines Gehäuses.

Im den folgenden Figuren verweisen gleiche Bezugszeichen auf funktionell oder strukturell entsprechende Teile der verschiedenen Ausführungsformen.

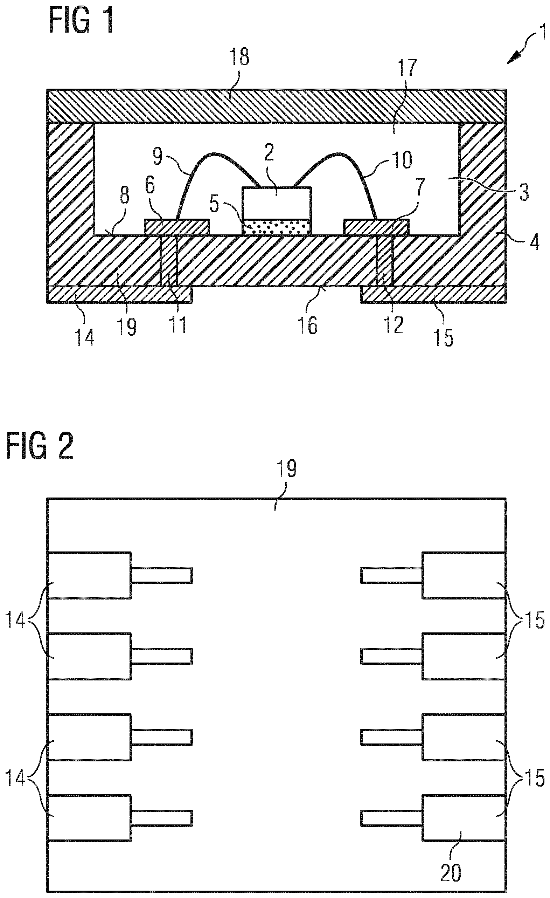

Figur 1 zeigt ein nicht-erfindungsgemäßes Gehäuse 1 für einen Halbleiterchip 2. Der Halbleiterchip ist in einem Aufnahmeraum 3 des Gehäuses 1 angeordnet.

Das Gehäuse 1 weist einen spritzgegossenen Körper 4 auf, der aus einem Kunststoff-Material in einem Spritzgussverfahren hergestellt ist. Der spritzgegossene Körper 4 weist Metallisierungen 6, 7, 11, 12, 14, 15 zur Kontaktierung des Halbleiterchips auf.

Der spritzgegossene Körper 4 hat somit sowohl die Funktion eines Gehäuses für den Halbleiterchip 2 als auch die Funktion eines Schaltungsträgers und ist als MID ausgebildet.

Der Halbleiterchip 2 ist am Boden 19 des spritzgegossenen Körper 4, beispielsweise mittels eines Klebstoffs 5 befestigt.

Das Gehäuse weist innere Metallisierungen 6, 7 auf, die auf einer Oberfläche 8 des spritzgegossenen Körpers 4 im Aufnahmeraum 3 des Gehäuses 1 vorgesehen sind. Das Gehäuse weist weitere innere Metallisierungen auf, die in Figur 1 durch die inneren Metallisierungen verdeckt sind und deshalb hier nicht zu sehen sind. Die inneren Metallisierungen 6, 7 sind über Verbindungsdrähte 9, 10 elektrisch mit dem Halbleiterchip 2 verbunden.

Das Gehäuse 1 weist weitere Metallisierungen auf, die als Durchkontaktierungen 11, 12 ausgebildet sind. Die Durchkontaktierungen 11, 12 sind elektrisch mit jeweils einer inneren Metallisierung 6, 7 verbunden und führen durch den spritzgegossenen Körper 4 hindurch. Somit stellen die Durchkontaktierungen 11, 12 eine elektrische Verbindung der inneren Metallisierung 6, 7 zu einer Außenseite 13 des Gehäuses 1 her.

Auf der Außenseite 13 des Gehäuses sind äußere Metallisierungen 14, 15 vorgesehen, die in direktem elektrischen Kontakt mit den Durchkontaktierungen 11, 12 stehen. Die äußeren Metallisierungen 14, 15 sind auf einer äußeren Oberfläche 16 des Gehäuses 1 angeordnet. Somit wird eine elektrische Kontaktierung des Halbleiterchips 2 von außen ermöglicht. Das Gehäuses 1 kann auf eine Leiterplatte (hier nicht gezeigt) aufgesetzt werden und mit dieser elektrisch verbunden werden. Insbesondere kann es so auf die Leiterplatte aufgesetzt werden, dass die äußeren Metallisierungen 14, 15 auf der Leiterplatte aufliegen.

Zur Herstellung der Durchkontaktierungen 11, 12 werden vorzugsweise bereits im Spritzgussverfahren, in dem der spritzgegossenen Körper 4 hergestellt wird, Durchführungen im Körper 4 gebildet. Dabei ist vorzugsweise das Material des Körpers 4, durch den die Durchführungen durchgeführt sind, ein metallisierbarer Kunststoff. Anschließend werden die Durchführungen mit einem metallischen Material gefüllt, so dass die inneren Metallisierungen 6, 7 ausgebildet werden.

Zur Herstellung der inneren Metallisierungen 6, 7 und der äußeren Metallisierungen 14, 15 wird vorzugsweise nach dem Spritzgießen des spritzgegossenen Körpers 4 ein metallisches Material auf eine innere Oberfläche 8 und eine äußere Oberfläche 16 des Körpers 4 aufgebracht. Dabei sind vorzugsweise die Bereiche der Oberflächen 8, 16 des Körpers 4, an dem die inneren 6, 7 und die äußeren Metallisierungen 14, 15 ausgebildet werden, aus einem metallisierbaren Kunststoff. Somit kann durch die Anordnung des metallisierbaren Kunststoffs eine Anordnung der Metallisierungen, insbesondere eine Leiterbahnstruktur, festgelegt werden.

Vorzugsweise weist der spritzgegossene Körper 4 an den Stellen, auf die eine Metallisierung aufgebracht werden soll einen metallisierbaren Kunststoff auf und an den Stellen, die frei von einer Metallisierung sein sollen, einen nicht-metallisierbaren Kunststoff auf. Beispielsweise ist ein derartiger Körper 4 in einem Zweikomponenten-Spritzgussverfahren hergestellt.

Der Aufnahmeraum 3 des Gehäuses 1 ist mit einer Vergussmasse 17 gefüllt. Auf diese Weise kann eine Passivierung des Halbleiterchips 2 hergestellt werden. Beispielsweise weist die Vergussmasse ein weiches Gel auf.

Das Gehäuse 1 weist einen Deckel 18 auf, der den Aufnahmeraum 3 nach außen hin abschließt. Der Deckel 18 ist am spritzgegossenen Körper 4 befestigt.

Beispielsweise ist der Deckel 4 aus einem Kunstoff-Material gebildet. Der Deckel 4 kann mittels Klebens oder Ultraschallschweißens am spritzgegossenen Körper 4 befestigt sein. Eine Verbindung mittels Ultraschall-Schweißens hat den Vorteil, dass auf diese Weise ein besonders dichtes Gehäuse 1 realisiert werden kann. Vorzugsweise ist das Gehäuse 1 hermetisch dicht abgeschlossen.

Figur 2 zeigt eine Aufsicht von außen auf den Boden 19 des Gehäuses 1, auf dem die äußeren Metallisierungen 14, 15 aufgebracht sind. Die äußeren Metallisierungen 14, 15 weisen Anschlusspads 20 zur elektrischen Kontaktierung des Halbleiterchips auf. Die Anschlusspads 20 können beispielsweise mit einer Leiterbahnstruktur einer Leiterplatte verlötet werden. In der Figur sind acht äußere Metallisierungen 14, 15 und acht Anschlusspads 20 abgebildet.

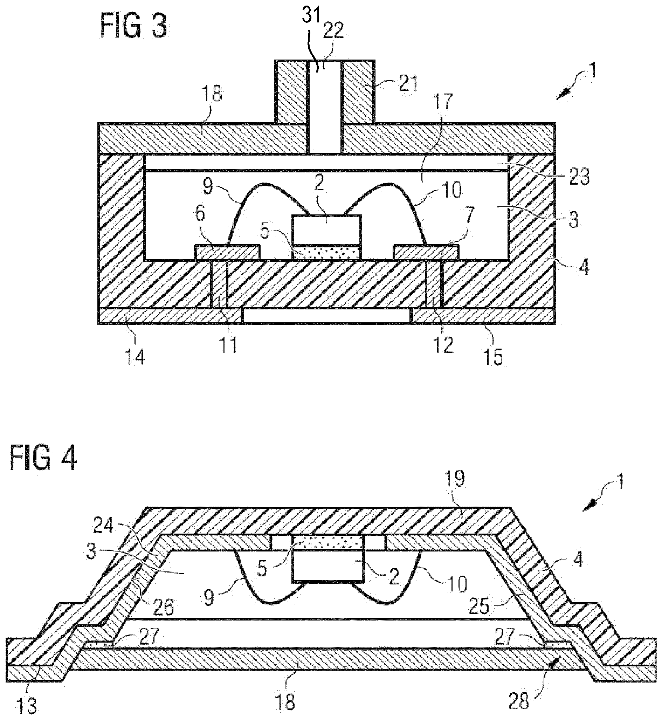

Figur 3 zeigt eine zweite Ausführungsform eines nichterfindungsgemäßen Gehäuses 1, bei der die elektrische Kontaktierung des Halbleiterchips 2 wie in der ersten Ausführungsform gemäß Figur 1 ausgeführt ist. Der Halbleiterchip 2 und das zugehörige Gehäuse 1 sind beispielsweise zur Messung eines absoluten Drucks ausgebildet. Alternativ kann der Halbleiterchip 2 zur Messung einer Beschleunigung oder zur Messung einer Drehzahl ausgebildet sein. Beispielsweise kann der Halbleiterchip 2 als Magnetsensor ausgebildet sein. Das Gehäuse 1 kann der jeweiligen Funktionalität angepasst sein.

Das Gehäuse 1 weist eine Öffnung 31 auf, welche in den Aufnahmeraum 3 führt. Beispielsweise weist der Deckel 18 eine Öffnung 31 auf. Beispielsweise ist die Öffnung 31 als Anschlussbereich 21 ausgebildet, durch den eine Zuleitung 22, beispielsweise für ein fluides Medium, dessen Druck bestimmt werden soll, führt. Beispielsweise ist die Zuleitung 22 mit Luft gefüllt. Alternativ kann über die Öffnung 31 eine Entlüftung des Aufnahmeraums 3 stattfinden. Insbesondere kann ein Druckausgleich mit der Umgebung stattfinden. In einer Ausführungsform kann die Öffnung 31 mit einer Membran oder einem Ventil versehen sein (nicht dargestellt). Beispielsweise kann die Membran halbdurchlässig ausgebildet sein.

Der Aufnahmeraum 3 des Gehäuses 1 ist teilweise mit einer Vergussmasse 17 gefüllt. Die Vergussmasse 17 füllt den Aufnahmeraum 3 nicht bis zum Deckel 18 aus. Zwischen der Unterseite des Deckels 18 und der Vergussmasse 17 ist ein Freiraum 23 vorgesehen. Der Freiraum 23 ist beispielsweise mit Luft gefüllt. Alternativ kann die Vergussmasse 17 den Aufnahmeraum 3 des Gehäuses 1 vollständig ausfüllen. Dies ermöglicht eine besonders gute Abdichtung und Passivierung des Halbleiterchips 2.

Der Boden 19 des Gehäuses ist genauso ausgebildet wie der in Figur 2 gezeigte Boden 19 des Gehäuses aus Figur 1.

Figur 4 zeigt eine dritte Variante eines erfindungsgemäßen Gehäuses 1 für einen Halbleiterchip 2. Die elektrische Kontaktierung des Halbleiterchips 2 wird bei dieser Ausführungsform durch Metallisierungen 24, 25 erzielt, die an einer Oberfläche 26 des spritzgegossenen Körpers 4 angeordnet sind und an der Oberfläche 26 entlang vom Aufnahmeraum 3 auf eine Außenseite 13 des Körpers führen. Die elektrische Kontaktierung ist somit frei von Durchkontaktierungen, die durch den spritzgegossenen Körper 4 hindurchführen.

Die Metallisierungen 24, 25 führen auf der Seite des Gehäuses 1 aus dem Aufnahmeraum 3 heraus, auf der der Deckel 18 des Gehäuses 1 angeordnet ist. Der äußere elektrische Anschluss des Halbleiterchips 2 ist somit bei dieser Ausführungsform auf der anderen Seite relativ zum Aufnahmeraum 3 des Gehäuses 1 vorgesehen als bei der Ausführungsform gemäß den Figuren 1 und 3.

Der spritzgegossene Körper 4 des Gehäuses 1 ist an der Seite, an der der Deckel 18 angeordnet ist, stufenförmig ausgebildet, so dass ein Aufnahmebereich 28 für den Deckel 18 ausgebildet ist. Der Deckel 18 des Gehäuses 1 ist mit einem Klebstoff 27 im Aufnahmebereich 28 am spritzgegossenen Körper 4 befestigt. Der Aufnahmebereich 28 gewährleistet eine besonders gute Positionierung des Deckels 18 relativ zum Körper 4 und eine besonders gute Abdichtung des Aufnahmeraums 3 .

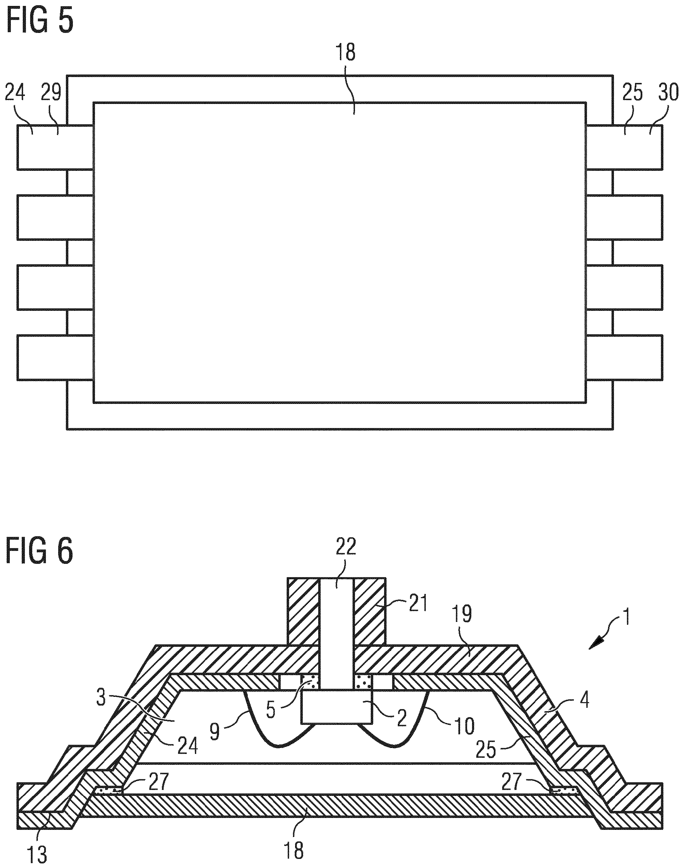

Figur 5 zeigt eine Aufsicht von außen auf den Deckel 18 des Gehäuses 1. Der spritzgegossene Körper 4 ist derart ausgebildet, dass Anschlusspins 29, 30 aus mit Metallisierungen 24, 25 versehenen Teilen des Körpers 4 gebildet sind. Das Gehäuse 1 kann auf eine Leiterplatte gesetzt werden, so dass die Anschlusspins 29, 30 an die Leiterplatte angrenzen und mit Leiterbahnen der Leiterplatte elektrisch kontaktiert werden können. Somit grenzt bei einer derartigen Montage der Deckel 18 des Gehäuses 1 an die Leiterplatte an, während der Boden 19 von der Leiterplatte abgewandt ist.

Figur 6 zeigt eine vierte, erfindungsgemäße Ausführungsform eines Gehäuses 1 für einen Halbleiterchip 2. Der Halbleiterchip 2 und das Gehäuse 1 sind beispielsweise für eine Messung eines relativen Drucks, d.h., als Relativdrucksensor, ausgebildet. Dabei wird der Druck eines fluiden Mediums, z. B. Luft, das in der Zuleitung zu einem drucksensitiven Bereich des Halbleiterchips 2 geführt ist, gegenüber dem Umgebungsdruck des Halbleiterchips 2 ermittelt. Die Vergussmasse ist derart ausgebildet, dass ein Umgebungsdruck an den Halbleiterchip 2 übertragen werden kann. Alternativ sind der Halbleiterchip 2 und das Gehäuse 1 zur Messung einer Beschleunigung, insbesondere als Inertialsensor, oder zur Messung einer Drehzahl, insbesondere als Magnetsensor ausgebildet.

Das Gehäuse 1 weist auf der dem Deckel 18 gegenüber liegenden Seite einen Anschlussbereich 21 mit einer Zuleitung 22 zur Zuführung eines fluiden Mediums auf den Halbleiterchip 2 auf. Der Halbleiterchip 2 ist unterhalb der Zuleitung 22 mittels eines Klebstoffs 5 am Gehäuse 1 befestigt.

Beispielsweise kann ein Teil des spritzgegossenen Körpers 4 oder der Deckel 18 mit einem oder mehreren Löchern versehen sein, durch die der Umgebungsdruck des Gehäuses auf einen drucksensitiven Bereich des Halbleiterchip 2 übertragen wird. In diesem Fall kann ein Druck eines in der Zuleitung 22 geführten fluiden Mediums relativ zum Umgebungsdruck des Gehäuses 1 ermittelt werden.

Die elektrische Kontaktierung des Halbleiterchips 2 ist wie die elektrische Kontaktierung der Ausführungsform gemäß den Figuren 4 und 5 ausgebildet.

### Bezugszeichenliste

- 1: Gehäuse
- 2: Halbleiterchip
- 3: Aufnahmeraum
- 4: spritzgegossener Körper
- 5: Klebstoff zur Befestigung des Halbleiterchips
- 6: innere Metallisierung
- 7: innere Metallisierung
- 8: innere Oberfläche
- 9: Verbindungsdraht
- 10: Verbindungsdraht
- 11: Durchkontaktierung
- 12: Durchkontaktierung
- 13: Außenseite
- 14: äußere Metallisierung
- 15: äußere Metallisierung
- 16: äußeren Oberfläche
- 17: Vergussmasse
- 18: Deckel
- 19: Boden
- 20: Anschlusspad
- 21: Anschlussbereich
- 22: Zuleitung
- 23: Freiraum
- 24: Metallisierung
- 25: Metallisierung
- 26: Oberfläche
- 27: Klebstoff zur Befestigung des Deckels
- 28: Aufnahmebereich
- 29: Anschlusspin
- 30: Anschlusspin
- 31: Öffnung

## Patentansprüche

1. Gehäuse für einen Halbleiterchip,
wobei das Gehäuse (1) einen spritzgegossenen Körper (4) aufweist, in dem ein Aufnahmeraum (3) zur Aufnahme des Halbleiterchips (2) vorgesehen ist,
wobei der spritzgegossene Körper (4) wenigstens eine Metallisierung (6, 7, 11, 12, 14, 15, 24, 25) zur elektrischen Kontaktierung des Halbleiterchips (2) aufweist,
wobei das Gehäuse (1) Anschlusspins (29, 30) aufweist, die aus mit der Metallisierung (24, 25) versehenen Teilen des Körpers (4) gebildet sind,
wobei mehrere Anschlusspins (29, 30) auf derselben Seite des Gehäuses (1) nebeneinander angeordnet sind, in einer Aufsicht auf die Metallisierung (24, 25) seitlich vom Rest des Körpers (4) abstehen und durch Ausnehmungen im Körper (4) voneinander beabstandet sind.

2. Gehäuse nach Anspruch 1,
bei dem die Metallisierung (6, 7, 11, 12, 14, 15, 24, 25) zumindest teilweise im Aufnahmeraum (3) angeordnet ist.

3. Gehäuse nach einem der Ansprüche 1 oder 2,
bei dem die Metallisierung (24, 25) zumindest teilweise im Aufnahmeraum (3) vorgesehen ist und entlang einer Oberfläche (26) des Körpers aus dem Aufnahmeraum (3) herausführt.

4. Gehäuse nach einem der Ansprüche 1 bis 3,
das einen Deckel (18) zur Verschließung des Aufnahmeraums (3) aufweist.

5. Gehäuse nach Anspruch 4,
das auf der dem Deckel (18) gegenüber liegenden Seite einen Anschlussbereich (21) mit einer Zuleitung (22) zur Zuführung eines fluiden Mediums auf den Halbleiterchip (2) aufweist.

6. Gehäuse nach einem der Ansprüche 1 bis 5,
das derart ausgebildet ist, das der Aufnahmeraum (3) hermetisch dicht abgeschlossen ist.

7. Gehäuse nach einem der vorhergehenden Ansprüche, bei dem der Körper als MID ausgebildet ist.

8. Halbleiterchip mit einem Gehäuse nach einem der Ansprüche 1 bis 7, wobei der Halbleiterchip (2) im Aufnahmeraum (3) des Gehäuses (1) angeordnet ist.

## Claims

1. Housing for a semiconductor chip,
wherein the housing (1) has an injection-moulded body (4), in which an accommodating area (3) for accommodating the semiconductor chip (2) is provided,
wherein the injection-moulded body (4) has at least one metallization (6, 7, 11, 12, 14, 15, 24, 25) for making electrical contact with the semiconductor chip (2),
wherein the housing (1) has connection pins (29, 30) which are formed from parts of the body (4) that are provided with the metallization (24, 25),
wherein a plurality of connection pins (29, 30) are arranged next to one another on the same side of the housing (1), protrude from the rest of the body (4) at the side in a plan view of the metallization (24, 25) and are spaced apart from one another by cutouts in the body (4) .

2. Housing according to Claim 1,
in which the metallization (6, 7, 11, 12, 14, 15, 24, 25) is arranged at least partly in the accommodating area (3) .

3. Housing according to either of Claims 1 and 2,
in which the metallization (24, 25) is provided at least partly in the accommodating area (3) and leads out of the accommodating area (3) along a surface (26) of the body.

4. Housing according to one of Claims 1 to 3,
which has a lid (18) for closing the accommodating area (3) .

5. Housing according to Claim 4,
which, on that side situated opposite the lid (18), has a connection region (21) with a feed line (22) for feeding a fluid medium onto the semiconductor chip (2).

6. Housing according to one of Claims 1 to 5,
which is embodied in such a way that the accommodating area (3) is hermetically impermeably sealed.

7. Housing according to one of the preceding claims, in which the body is embodied as an MID.

8. Semiconductor chip having a housing according to one of Claims 1 to 7, wherein the semiconductor chip (2) is arranged in the accommodating area (3) of the housing (1) .

## Revendications

1. Boîtier destiné à une puce à semi-conducteur,
le boîtier (1) comportant un corps (4) moulé par injection dans lequel est prévu un espace de réception (3) destiné à recevoir la puce à semi-conducteur (2),
le corps (4) moulé par injection comportant au moins une métallisation (6, 7, 11, 12, 14, 15, 24, 25) destinée à la mise en contact électrique de la puce à semi-conducteur (2),
le boîtier (1) comportant des broches de connexion (29, 30) qui sont formées de parties du corps (4) qui sont pourvues de la métallisation (24, 25),
une pluralité de broches de connexion (29, 30) étant disposées les unes à côté des autres sur le même côté du boîtier (1), faisant saillie latéralement du reste du corps (4) en vue de la métallisation (24, 25) et étant espacées les unes des autres par des évidements ménagés dans le corps (4).

2. Boîtier selon la revendication 1, dans lequel la métallisation (6, 7, 11, 12, 14, 15, 24, 25) est au moins partiellement disposée dans l'espace de réception (3).

3. Boîtier selon l'une des revendications 1 ou 2, dans lequel la métallisation (24, 25) est au moins partiellement prévue dans l'espace de réception (3) et sort de l'espace de réception (3) le long d'une surface (26) du corps.

4. Boîtier selon l'une des revendications 1 à 3, lequel comporte un couvercle (18) destiné à fermer l'espace de réception (3).

5. Boîtier selon la revendication 4, lequel comporte une zone de connexion (21) pourvue d'une conduite d'amenée (22) destinée à amener un milieu fluide sur la puce à semi-conducteur (2) du côté qui est opposé au couvercle (18).

6. Boîtier selon l'une des revendications 1 à 5, lequel est conçu de manière à ce que l'espace de réception (3) soit fermé hermétiquement.

7. Boîtier selon l'une des revendications précédentes, dans lequel le corps est conçu sous la forme d'un MID.

8. Puce à semi-conducteur comportant un boîtier selon l'une des revendications 1 à 7, la puce à semi-conducteur (2) étant disposée dans l'espace de réception (3) du boîtier (1).
